**Europäisches Patentamt**

**European Patent Office**

**Office européen des brevets**

(19)

(11) Veröffentlichungsnummer: **0 170 012**
**B1**

(12) # EUROPÄISCHE PATENTSCHRIFT

(45) Veröffentlichungstag der Patentschrift:
19.04.89

(51) Int. Cl.⁴: **C 04 B 41/90, C 04 B 37/02**

(21) Anmeldenummer: **85107213.2**

(22) Anmeldetag: **12.06.85**

(54) Metall-Keramik-Verbundelement und Verfahren zu dessen Herstellung.

(30) Priorität: **06.07.84 CH 3275/84**

(43) Veröffentlichungstag der Anmeldung:
**05.02.86 Patentblatt 86/6**

(45) Bekanntmachung des Hinweises auf die Patenterteilung:
**19.04.89 Patentblatt 89/16**

(84) Benannte Vertragsstaaten:
**CH DE FR GB IT LI NL**

(56) Entgegenhaltungen:
**EP-A-0 013 433**
**EP-A-0 097 058**
**EP-A-0 123 212**
**DE-A-2 540 015**
**GB-A-1 294 695**
**US-A-3 994 430**
**US-A-4 457 958**

**CHEMICAL ABSTRACTS, Band 99, Nr. 22, 28.
November 1983, Seite 287, Nr. 180491m, Columbus,
Ohio, US; & JP - A - 58 99 183 (HITACHI LTD.)
13.06.1983**
**CHEMICAL ABSTRACTS, Band 101, Nr. 24,
Dezember 1984, Seite 249, Nr. 215431f, Columbus,
Ohio, US; & JP - A - 59 121 175 (TOSHIBA CORP.)
13.07.1984**

(73) Patentinhaber: **BBC Brown Boveri AG,
Haselstrasse, CH- 5401 Baden (CH)**

(72) Erfinder: **Gobrecht, Jens, Dr., Birchhof 6, CH- 5412
Gebenstorf (CH)**
Erfinder: **Neidig, Arno, Dr., Brühlerweg 42, D-6831
Plankstadt (DE)**

EP 0 170 012 B1

## Beschreibung

Die vorliegende Erfindung betrifft ein Metall-Keramik-Verbundelement gemäss dem Oberbegriff des Anspruchs 1 sowie ein Verfahren zur Herstellung eines solchen Verbundelements. Dieses Verbundelement ist Gegenstand der älteren Anmeldung EP-A2 0 123 212.

In der Technik der Leistungshalbleiter und Hybridschaltungen bzw. Leistungsmodule finden zunehmend Metall-Keramik-Verbindungen Verwendung, die ohne Löten oder Kleben nach dem sogenannten "direct bonding"-Verfahren hergestellt werden (siehe z. B. US-A 3 994 430).

Bei diesem "direct bonding"-Verfahren wird eine Metallschicht mit einem darunterliegenden Keramiksubstrat durch eine eutektische Zwischenschicht fest verbunden. Die eutektische Zwischenschicht besteht aus einem Eutektikum, das aus dem Metall der Metallschicht (z. B. Cu) und einer entsprechenden Metallverbindung (z. B. $Cu_2O$) gebildet wird und dessen Schmelzpunkt unterhalb dem des reinen Metalls liegt.

Bei der Herstellung der Verbindung wird die Metallschicht in Form einer Folie auf das Keramiksubstrat gelegt und die so gebildete Schichtanordnung auf eine Temperatur zwischen der eutektischen Temperatur und der Schmelztemperatur des reinen Metalls erhitzt. Eine das Keramiksubstrat benetzende, flüssige eutektische Zwischenschicht bildet sich unter diesen Bedingungen dann aus, wenn die Erhitzung entweder in einer reaktiven Atmosphäre erfolgt (U5-A 3 766 634) oder, wie im Falle einer Cu-Metallschicht, der benötigte Sauerstoff durch vorherige Oxidation der Cu-Folie in die Zwischenschicht eingebracht wird (US-A-3 994 430).

Mittels des bekannten Verfahrens sind mit Erfolg feste Verbindungen zwischen verschiedenartigen Metallschichten, insbesondere jedoch aus Cu, und Keramikschichten aus $Al_2O_3$ oder BeO hergestellt und z. B. als Substrate für Hybridschaltungen verwendet worden. Die Metallschicht wird in solchen Fällen strukturiert und bildet Leiterflächen und Leiterbahnen, auf welche dann diskrete Bauelemente aufgelötet werden. Die thermische Belastbarkeit einer solchen Hybridschaltung wird dabei im wesentlichen durch die Wärmeleitfähigkeit des Keramiksubstrats bestimmt, über das die in den Bauelementen entstehende Wärme an eine Kühlfläche oder die Umgebung abgegeben wird.

Sowohl bei integrierten Schaltungen wie auch in Modulen der Leistungselektronik werden jedoch die Flächen der Aktivteile und die pro Flächeneinheit abzuführende Verlustleistung ständig grösser. Diese Zunahme in der thermischen Belastung stellt an die thermische Ankopplung der Bauelemente und damit an die thermischen Eigenschaften des Keramiksubstrats erhöhte Anforderungen.

Die konventionelle Technik, bei der (z. B. durch "direct bonding") metallisierte $Al_2O_3$-Keramiksubstrate als Träger diskreter Bauelemente oder Chips verwendet werden, stösst heute bereits an ihre Grenzen. Die Gründe hierfür liegen in der relativ kleinen Wärmeleitfähigkeit von $Al_2O_3$-Keramik von etwa 20 - 25 $W \cdot m^{-1} \cdot K^{-1}$ sowie darin, dass der thermische Ausdehnungskoeffizient mehr als doppelt so gross ist wie der des gebräuchlichsten Halbleitermaterials Silizium. Die Verwendung der thermisch besser leitenden BeO-Keramik anstelle von $Al_2O_3$ ist wegen der Giftigkeit des bei der Bearbeitung anfallenden Staubes im Normalfall mit Schwierigkeiten verbunden.

Aus den genannten Gründen erhalten seit kurzem Keramikwerkstoffe grosse Beachtung, die neben einer hohen Wärmeleitfähigkeit einen kleinen Wärmeausdehnungskoeffizienten und eine gute elektrische Isolationsfähigkeit aufweisen. Zu diesen Keramikwerkstoffen gehöhren die Nitridkeramiken, insbesondere AIN und $Si_3N_4$. Gerade die Aluminiumnitrid-Keramik zeichnet sich durch eine Wärmeleitfähigkeit von etwa 100 $W \cdot m^{-1} \cdot K^{-1}$ aus, die viermal höher ist, als die der bisher verwendeten $Al_2O_3$-Keramik.

Die Verwendung von Nitridkeramiken als metallisierte Substrate für die Montage von Leistungsbauelementen wirft jedoch Probleme auf, weil herkömmliche Metallisierungsverfahren, insbesondere das beschriebene "direct bonding"-Verfahren, nicht zu einer hinreichend festen Metall-Keramik-Verbindung führen. Gerade die technologisch wichtige Cu-Keramik-Direktverbindung mit der bekannten Schichtfolge Cu-Metallschicht, eutektische Zwischenschicht aus $Cu-Cu_2O$ und Keramiksubstrat ist für ein Keramiksubstrat aus Nitridkeramik wegen mangelnder Haftfestigkeit ungeeignet (siehe z. B. EP-A2-0 097 944).

Es ist deshalb vorgeschlagen worden (EP-A2-0 097 944 oder EP-A2-0 123 212), bei Keramiken ohne Sauerstoffanteil, wie z. B. Nitridkeramiken, auf der Verbindungsfläche des Keramiksubstrats zunächst eine Oxyd-Zwischenschicht zu erzeugen, die dann von der eutektischen Schmelze ausreichend benetzt werden kann.

Bei den letztgenannten Verfahren wird jedoch nicht berücksichtigt, dass nur eine spezielle Wahl der Dicke dieser Oxyd-Zwischenschicht nicht nur eine ausreichende Haftfestigkeit vermittelt, sondern auch die thermischen Vorteile einer Nitridkeramik voll zur Geltung bringt.

Der Erfindung liegt daher die Aufgabe zugrunde, ein Metall-Nitrid-Keramik-Verbundelement zu schaffen, das sich gegenüber dem bekannten Metall-$Al_2O_3$-Verbundelement bei im wesentlichen-unverminderter mechanischer Festigkeit durch eine deutlich verbesserte Wärmeleitfähigkeit auszeichnet, sowie ein Verfahren zur Herstellung eines solchen Verbundelements anzugeben.

Die Aufgabe wird bei einem Metall-Keramik-Verbundelement der eingangs genannten Art durch die Merkmale aus dem Kennzeichen des Anspruchs 1 gelöst. Das Herstellungsverfahren ist durch die Merkmale des Anspruchs 4 gekennzeichnet.

Der Kern der Erfindung besteht darin, ein Keramiksubstrat aus einer Nitridkeramik vorzusehen und die Hafteigenschaften zwischen Nitridkeramik und der eutektischen Zwischenschicht durch eine Oxyd-Zwischenschicht definierter Dicke zu verbessern die mit der Nitridkeramik fest verbunden ist und von der eutektischen Zwischenschicht benetzt wird.

Das Herstellungsverfahren sieht die Verwendung einer Nitridkeramik als Substrat vor, die zunächst durch einen Temperprozess in einer sauerstoffhaltigen Atmosphäre mit einer Oxyd-Zwischenschicht überzogen wird und anschliessend in an sich bekannter Weise metallisiert werden kann.

Die Erfindung soll nun nachfolgend im Zusammenhang mit der Zeichnung anhand eines Ausführungsbeispieles näher erläutert werden. Es zeigen:

Fig. 1     die Schichtenfolge eines erfindungsgemässen Metall-Keramik-Verbundelements;

Fig. 2A-D   die verschiedenen Stadien bei der Herstellung eines erfindungsgemässen Metall-Keramik-Verbundelements.

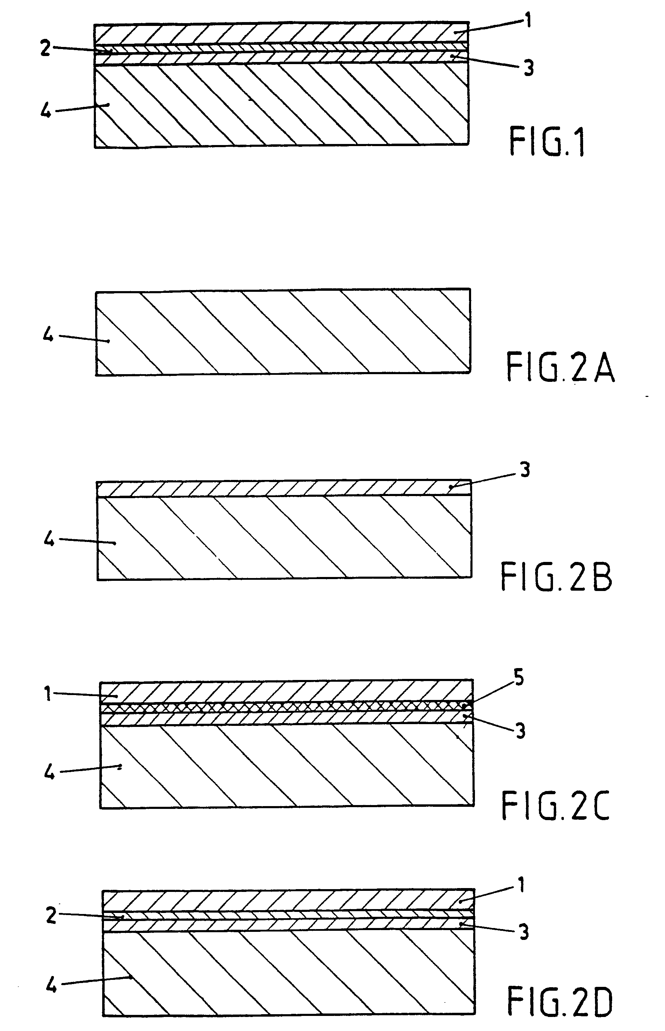

Die Schichtenfolge des erfindungsgemässen Metall-Keramik-Verbundelements ist in Fig. 1 dargestellt. Auf einem Keramiksubstrat 4 aus Nitridkeramik ist eine aufgewachsene Oxyd-Zwischenschicht 3 angeordnet, die in dem nachfolgenden noch näher beschriebenen Verfahren durch Temperung des Keramiksubstrats 4 in einer sauerstoffhaltigen Atmosphäre bei über 1000° C hergestellt worden ist. Die Oxyd-Zwischenschicht 3 ist aufgrund der Herstellungsart mit dem Keramiksubstrat 4 fest verbunden und wirkt wegen ihres Oxydgehalts wie die Oberfläche der bekannten $Al_2O_3$- oder BeO-Kersmik, d. h. wird von einer nachfolgenden eutektischen Zwischenschichl 2 im flüssigen Zustand während des "direct bonding"-Prozesses benetzt.

Die nach der Abkühlung erstarrte eutektische Zwischenschicht 2 bewirkt eine feste Verbindung zwischen der Oxyd-Zwischenschicht 3 und einer obenliegenden Metallschicht 1, die strukturiert sein kann und z. B. Leiterbahnen und -flächen für aktive Bauelemente bildet.

Das Keramiksubstrat 4 besteht vorzugsweise aus AIN oder $Si_3N_4$, wobei sich Aluminiumnitrid gegenüber Siliziumnitrid durch eine höhere Wärmeleitfähigkeit auszeichnet. Andere geeignete Nitride können jedoch ebenfalls Verwendung finden.

Die eutektische Zischenschicht 2 besteht aus einer eutektischen Legierung des Metalls der Metallschicht 1 und geeigneten Metallverbindungen. Beispiele für die Metalle und Metallverbindungen können aus der US-A-3 994 430 entnommen werden. Bevorzugt wird eine Metallschicht 1 aus Kupfer und eine eutektische Zwischenschicht 2 aus einer Cu-Cu₂O-Legierung, die sich durch eine relativ niedrige euteklische Temperstur von etwa 1065° C auszeichnet.

Die genaue Zusammensetzung der Oxyd-Zwischenschicht 3 ist noch nicht geklärt. Der Sauerstoffanteil liegt jedoch deutlich über 50 %, wobei die Sauerstoffatome entweder in Form von $Al_2O_3$ (bei AIN) bzw. $SiO_2$ (bei $Si_3N_4$) oder von Oxydnitriden gebunden sind.

Die Dicke der Oxyd-Zwischenschicht 3, die von der Zeitdauer der Temperung in der sauerstoffhaltigen Atmosphäre abhängt, muss oberhalb eines Minimalwertes liegen, um eine ausreichende Haftung zwischen Metallschicht 1 und Keramiksubstrat 4 zu gewährleisten. Sie darf darüber hinaus nicht zu gross gewählt werden, weil sich die Wärmeleitfähigkeit durch die Schichtfolge der Fig. 1 mit zunehmender Dicke der Oxyd-Zwischenschicht verschlechtert. Der erfindungsgemässe Dickenbereich erstreckt sich von 0,2 μm bis etwa 5 μm.

Bei dem erfindungsgemässen Verfahren zur Herstellung des Metall-Keramik-Verbundelements mit verbesserter Wärmeleitfähigkeit wird gemäss Fig. 2A von dem Keramiksubstrat 4 aus Nitridkeramik ausgegangen.

Auf dem Keramiksubstrat 4 wird durch thermische Oxidation die Oxyd-Zwischenschicht 3 erzeugt (Fig. 2B). Dabei geht man folgendermassen vor: Das Keramiksubstrat 4 wird gereinigt, getrocknet und dann in einem Ofen bei Temperaturen zwischen 1100° C und 1300° C für eine Zeit von 5 bis 60 Minuten in Luft oder reinem Sauerstoff geglüht (getempert). Dabei bildet sich an der Oberfläche der Nitridkeramik die dünne, fest haftende Oxyd-Zwischenschicht. Je länger getempert wird, bzw. je höher die Temper-Temperatur ist, desto grösser wird die Dicke der Oxyd-Zwischenschicht 3, so dass sich durch Einstellung der Parameter Temperatur und Zeit die nötige Dicke problemlos steuern lässt.

Für die nachfolgende Metallisierung des Keramiksubstrats 4 nach dem bekannten "direct bonding"-Verfahren muss diese Dicke, wie bereits erwähnt, einen gewissen Minimalwert überschreiten, da beim Bondvorgang die Oxyd-Zwischenschicht teilweise in der flüssigen eutektischen Zwischenschicht gelöst wird.

**Patentansprüche**

1. Metall-Keramik-Verbundelement mit einem Keramiksubstrat (4), einer darüber liegenden Metallschicht (1) und einer zwischen dem Keramiksubstrat (4) und der Metallschicht (1) liegenden eutektischen Zwischenschicht (2), wobei das Keramiksubstrat (4) aus einer Nitridkeramik besteht und Zwischen der eutektischen Zwischenschicht (2) und dem Keramiksubstrat (4) eine Oxyd-Zwischenschicht (3) angeordnet ist, dadurch gekennzeichent, dass

die Oxyd-Zwischenschicht eine Dicke von 0,2 - 5 μm aufweist.

2. Verbundelement nach Anspruch 1, dadurch gekennzeichnet, dass die Nitridkeramik aus AlN oder Si₃N₄ besteht.

3. Verbundelement nach Anspruch 1, dadurch gekennzeichnet, dass die Metallschicht (1) aus Cu und die eutektische Zwischenschicht (2) aus Cu und Cu₂O besteht.

4. Verfahren zur Herstellung eines Metall-Keramik-Verbundelements nach Anspruch 1, bei welchem Verfahren eine Metallschicht (1) durch Bildung einer eutektischen Zwischenschicht (2) mit einem Keramiksubstrat (4) verbunden wird, dadurch gekennzeichnet, dass als Keramiksubstrat (4) eine Nitridkeramik verwendet wird und vor der Bildung der eutektischen Zwischenschicht (2) auf der der Metallschicht zugewandeten Seite des Keramiksubstrats zunächst eine Oxyd-Zwischenschicht (3) erzeugt wird.

5. Verfahren nach Anspruch 4, dadurch gekennzeichnet, dass als Nitridkeramik eine AlN- oder Si₃N₄-Keramik verwendet wird, und zur Erzeugung der Oxyd-Zwischenschicht (3) das Keramik Für die thermische Oxydstion von AlN-Substraten haben sich dabei die folgenden Parameter besonders bewährt:

Temperzeit:    30 Minuten
Temperatur:    1200° C
Atmosphäre:    Luft

Nach der Erzeugung der Oxyd-Zwischenschicht 3 gemäss Fig. 2B kann das Keramiksubstrat 4 in bekannter Weise durch "direct bonding" metallisiert werden. Dies ist in Fig. 2C beispielhart für das Aufbringen einer Cu-Folie nach dem aus US-A 3 994 430 bekannten Verfahren dargestellt.

In diesem Fall wird auf die Oxyd-Zwischenschicht 3 des thermisch oxydierten Keramiksubstrats 4 eine voroxydierte Cu-Folie gelegt, die aus der Metallschicht 1 und einer Metalloxydschicht 5 besteht. Durch Erhitzen sur Temperaturen oberhalb der eutektischen Temperatur (bei Cu-Cu₂O: 1065° C) bildet sich gemäss Fig. 2D die eutektische flüssige Zwischenschicht 2 aus, so dass nach dem Abkühlen die aus Fig. 1 bereits bekannte Schichtfolge entsteht.

Die Metallisierung ist naturgemäss nicht auf das hier beispielhaft angeführte Verfahren beschränkt, sondern kann mit allen Methoden durchgeführt werden, die bereits aus der Technologie der Oxydkeramiken bekannt sind.

Die mit der Oxyd-Zwischenschicht aur der Nitridkeramik erreichte Haftfestigkeit der Metallschicht ist vergleichbar mit der auf Al₂O₃-Keramik, so dass mit der Erfindung auf einfache weise Metall-Keramik-verbundelemente zur Verfügung gestellt werden können, die in ihren thermischen Eigenschaften bei gleichbleibender mechanischer Festigkeit deutlich überlegen sind.
substrat (4) in einer sauerstoffhaltigen Atmosphäre bei Temperaturen von mehr als 1000°C getempert wird.

6. Verfahren nach Anspruch 5, dadurch gekennzeichnet, dass als Nitridkeramik eine AlN-Keramik verwendet wird, und zur Erzeugung der Oxyd-Zwischenschicht (3) das Keramiksubstrat (4) in einer sauerstoffhaltigen Atmosphäre bei Temperaturen zwischen 1100° C und 1300° C für eine Zeit zwischen 5 und 60 Minuten getempert wird.

7. Verfahren nach Anspruch 6, dadurch gekennzeichnet, dass als sauerstoffhaltige Atmosphäre Luft oder reiner Sauerstoff verwendet wird.

8. Verfahren nach Anspruch 7, dadurch gekennzeichnet, dass als sauerstoffhaltige Atmosphäre Luft verwendet wird und das Keramiksubstrat (4) für ungefähr 30 Minuten bei einer Temperatur von ungefähr 1200° C getempert wird.

## Claims

1. Composite metal-ceramic element with a ceramic substrate (4), a metal layer (1) on top thereof and a eutectic interlayer (2) located between the ceramic substrate (4) and the metal layer (1), the ceramic substrate (4) consisting of a nitride-ceramic material and an oxide interlayer (3) being provided between the eutectic interlayer (2) and the ceramic substrate (4) characterised in that the oxide interlayer has a thickness 0.2 - 5 μm.

2. Composite element according to Claim 1, characterised in that the nitride-ceramic material consists of AlN or Si₃N₄.

3. Composite element according to Claim 1, character ised in that the metal layer (1) consists of Cu and the eutectic interlayer (2) consists of Cu and Cu₂O.

4. Process for the manufacture of a composite metalceramic element according to Claim 1, wherein a metal layer (1) is bonded to a ceramic substrate (4) by forming a eutectic interlayer (2), characterised in that a nitride-ceramic material is used as the ceramic substrate (4) and an oxide interlayer (3) is first generated on that side of the ceramic substrate which faces the metal layer, before the eutectic interlayer (2) is formed.

5. Process according to Claim 4, characterised in that an AlN- or Si₃H₄-ceramic is used as the nitride-ceramic material and, for generating the oxide interlayer (3), the ceramic substrate (4) is heat-treated at temperatures of more than 1000° C in an oxygen-containing atmosphere.

6. Process according to Claim 5, characterised in that an AlN-ceramic is used as the nitride-ceramic material and, for generating the oxide interlayer (3), the ceramic substrate (4) is heat-treated at temperatures between 1100° C and 1300°C in an oxygen-containing atmosphere for a period of between 5 and 60 minutes.

7. Process according to Claim 6, characterised in that air or pure oxygen is used as the oxygen-containing atmosphere.

8. Process according to Claim 7, characterised in that air is used as the oxygen-containing atmosphere and the ceramic substrate (4) is heat-treated at a temperature of approximately 1200° C for approximately 30 minutes.

## Revendications

1. Elément composite métal-céramique comprenant un substrat céramique (4), une couche métallique (1) se trouvant par-dessus et une couche intermédiaire eutectique (2) se trouvant entre le substrat céramique (4) et la couche métallique (1), le substrat céramique (4) consistant en une céramique de nitrure et une couche intermédiaire d'oxyde (3) étant agencée entre la couche intermédiaire eutectique (2) et le substrat céramique (4), caractérisé en ce que la couche intermédiaire d'oxyde a une épaisseur de 0,2 - 5μm.

2. Elément composite suivant la revendication 1, caractérisé en ce que la céramique de nitrure consiste en AlN ou en $Si_3N_4$.

3. Elément composite suivant la revendication 1, caractérisé en ce que la couche métallique (1) consiste en Cu et la couche intermédiaire eutectique (2) consiste en Cu et $Cu_2O$.

4. Procédé de fabrication d'un élément composite métal-céramique suivant la revendication 1, suivant lequel procédé une couche métallique (1) est unie à un substrat céramique (4) par formation d'une couche intermédiaire eutectique (2), caractérisé en ce qu'on utilise comme substrat céramique (4) une céramique de nitrure et avant de former la couche intermédiaire eutectique (2), on produit d'abord une couche intermédiaire d'oxyde (3) sur la face du substrat céramique tournée vers la couche métallique.

5. Procédé suivant la revendication 4, caractérisé en ce qu'on utilise une céramique d'AlN ou de $Si_3N_4$ comme céramique de nitrure et pour produire la couche intermédiaire d'oxyde (3), on recuit le substrat céramique (4) dans une atmosphère contenant de l'oxygène à des températures de plus de 1000° C.

6. Procédé suivant la revendication 5 caractérisé en ce qu'on utilise une céramique d'AlN comme céramique de nitrure et pour produire la couche intermédiaire d'oxyde (3), on recuit le substrat céramique (4) dans une atmosphère contenant de l'oxygène à des températures entre 1000° C et 1300° C pendant une durée entre 5 et 60 minutes.

7. Procédé suivant la revendication 6 caractérisé en ce qu'on utilise l'air ou l'oxygène pur comme atmosphère contenant de l'oxygène.

8. Procédé suivant la revendication 7 caractérisé en ce qu'on utilise l'air comme atmosphère contenant de l'oxygène et on recuit le substrat ceramique (4) pendant environ 30 minutes à une temperature d'environ 1200 C.

FIG.1

FIG.2A

FIG.2B

FIG.2C

FIG.2D